# EUROPEAN PATENT APPLICATION

(11) **EP 4 779 065 A1**
(43) Date of publication of application: **22.07.2026**
(21) Application number: 25159124.4
(22) Date of filing: 20.02.2025
(51) Int. Cl.: C30B 29/60, C30B 29/32, C04B 35/00, C30B 7/14

(54) **NANOCRYSTALLINE TUNGSTATE-BASED MATERIAL OF THE DOUBLE PEROVSKITE FAMILY, ITS PREPARATION METHOD AND APPLICATION**

(30) Priority: 20.01.2025 PL 45100525
(71) Applicant: Siec Badawcza Lukasiewicz - PORT Polski Osrodek Rozwoju Technologii, 54-066 Wroclaw (PL)
(72) Inventor: Prokop, Kacper, 57-200 Tarnów (PL); Guzik, Majgorzata, 53-333 Wroclaw (PL)
(74) Representative: JWP Patent & Trademark Attorneys

(57) **Abstract**

The object of the invention is a nanocrystalline material from the double perovskite family of the general formula Ba_{X}Sr_{1-X}LaLiWO ₆, wherein X is 0 to 1, crystallizing in the cubic crystal system in space group *Fm*3̅*m* and point symmetry *O*⁵ₕ having a nanocrystallite size not exceeding 40 nm. A further object of the invention is a method for preparing the nanocrystalline material from the double perovskite family. A further object of the invention is the use of the nanocrystalline material for the production of optical materials.

## Description

The object of the invention is a nanocrystalline tungstate-based material from the double perovskite family, a method for obtaining the nanocrystalline tungstate-based material from the double perovskite family and the use of the nanocrystalline material for the production of optical materials. The invention can be used, among others, in non-contact optical thermometry, as a source of white LED light or in solid-state lasers (random lasers).

Recently, attempts have also been made to produce, from the tungstates discussed herein, new transparent polycrystalline sintered ceramics, which could be used as phosphors, in laser technologies or as scintillators.

Chinese patent application CN105880585 A discloses a preparation method of nanocrystalline tungsten. Coarse crystalline tungsten is used as original ball milling material. Ball milling is performed under the protection of nitrogen or inert gas. This process is characterized by the use of absolute ethanol as a process control agent. Milling lasts from 40 to 80 hours, with a ball-to-powder ratio of 4:1 to 20:1 and at a speed in the range of 500 to 900 rpm. The process yields a nanocrystalline tungsten powder with a crystallite size below 30 nm, and the minimum crystallite size reaches 3 nm. The resulting tungsten powder is characterized by smaller crystallite dimensions, which translates into higher surface energy.

Chinese patent description CN115368144 B discloses a perovskite-structured nanopowder with piezoelectric properties, a method for its preparation, and a piezoelectric membrane which is prepared by tape casting from said ultrafine ceramic powder, are known. The piezoelectric ceramic powder includes PZT-based series (Pb (Zr_{0.52}Ti_{0.48})O₃), KNN (Na_{0.52}K_{0.44}Li_{0.04})(Nb_{0.89}Sb_{0.05}Ta_{0.06})O₃), PZN-PT (for example Pb (Zn_{1/3}Nb_{2/3})O₃PbTiO₃) and PMN-PT (Pb(Mg_{1/3}Nb_{2/3})O₃-PbTiO₃). The method for preparing the ultrafine piezoelectric ceramic powder comprises the following steps:
a) S1 - weighing raw materials in the form of piezoelectric powder and deionized water in an appropriate proportion, adding the raw materials in the form of piezoelectric powder and deionized water to a supreme grinder and grinding to form a first slurry;
b) S2 - adding ethyl alcohol to the first slurry, reducing the rotational speed of the supreme grinder and continuously grinding to form a second slurry;
c) S3 - removing and placing the second slurry in a laboratory oven, low-temperature drying, and then high-temperature drying to obtain fine powder;
d) S4 - sieving the dried fine powder to obtain piezoelectric nanopowder.

The method for preparing the ultrafine piezoelectric ceramic powder is simple, poses no risk of explosiveness, has no excessive powder waste and helps optimize production costs. The piezoelectric ultrafine powder has uniform particles that do not aggregate, and the piezoelectric ceramic membrane prepared therefrom and obtained by tape casting is characterized by the lack of cracking, pinholes or non-forming problems.

Chinese patent application CN113817467 A discloses a method for preparing a phosphor of the formula Cs₂AgInCl₆ and a double perovskite structure using ball milling. The product preparation process includes the following steps: adding of caesium salt, silver salt, sodium salt, indium salt and bismuth salt, which serve as reaction substrates in certain proportions. Then, an appropriate number of balls with a specific diameter is added and ball milling is performed in a mill for a specific period of time. The disclosed method is simple, effective, cheap and environmentally friendly. The double perovskite-structured powder obtained in this way, crystallizing in the cubic crystal system, has very good luminescent properties and can be used to produce LED devices emitting warm white light.

In the current state of the art, luminescent materials, also known as phosphors, are widely used in various areas of technology such as energy-saving lighting, including fluorescent tubes, compact bulbs and white LEDs. In addition, phosphors are used in ionizing radiation detectors, medical imaging and laser sources.

Tungstates doped with lanthanide ions are materials with a high potential in advanced technological applications due to their unique optical, magnetic and luminescent properties. These compounds are characterized by excellent mechanical strength and chemical and thermal stability. They form a huge number of varieties with varying structures. They are excellent matrices for rare earth ions such as Pr³⁺, Nd³⁺, Eu³⁺, Er³⁺, Ho³⁺, Tm³⁺ and Yb³⁺, whose emission occurs in a wide spectral range from ultraviolet (UV) to near infrared (NIR). They can be potentially used as phosphors, scintillators, laser devices and non-linear materials not only in the form of single crystals or glasses, but also in nano and micro powder form.

The key applications of luminescent tungstate-based materials include, among others:
1. Phosphors in lighting and displays: Lanthanide ion-doped tungstates show strong luminescence, which makes them ideal materials for applications in display technologies such as LEDs or fluorescent lamps. Lanthanide ions, especially those of europium, embedded in tungstate lattice structures, emit intense light in various spectral ranges, which allows for the colour of light to be adjusted.
2. Materials for radiation detectors: Lanthanide-doped tungstates are used in the detection of ionizing radiation (X, gamma radiation). Owing to their high luminescent efficiency, energy conversion and broadly defined stability, they are used in scintillation materials for detectors used in medical diagnostics, computed tomography or security technologies.
3. Optical materials in telecommunications: Owing to their unique optical properties, lanthanide-doped tungstates can be used in optical systems to amplify optical signals, which is important in long-distance data transmission technologies in telecommunications.
4. Bioimaging and medicine: Due to their luminescent properties, these materials can be used in medicine for bioimaging, enabling the location and visualization of various biological structures. They can also be used as tags in the diagnostics and photodynamic therapy of cancers.
5. Sensors and detectors: Lanthanide ion-doped tungstates can be used as sensory materials in optical detection systems to enable the monitoring of pollution, temperature, humidity or other environmental parameters.
6. Catalysis and photocatalysis: Nanometric tungstates can act as photocatalysts in chemical reactions such as degradation of organic pollutants in the environment under the influence of UV or visible radiation. The addition of lanthanide ions may increase the efficiency of these materials in environmental protection applications.

Nanometric lanthanide ion-doped tungstates, as shown above, are characterized by a wide range of potential applications, which makes them key materials in the development of modern technologies, especially in optoelectronics, medicine and environmental protection.

In 1974, Brixner described ALaBB'O₆ compounds (where A = Sr, Ba, B = Li, Na, K, B '= Mo, W) classifying them as ordered perovskites crystallizing in the cubic crystal system in space groupFm3m, No. 225 and point symmetry *O*⁵ₕ [1]. According to his research, SrLaLiWO₆ or BaLaLiWO₆ melt congruently, which makes it possible to grow single crystals using the Czochralski technique. However, their molybdenum-containing counterparts (SrLaLiMoO₆, BaLaLiMoO₆) could only be obtained using an additional parameter, which was the application of a pressure of 65 kbar. A renewed interest in this compound family could be observed in the first decade of the 21st century, when in 2007 Zhao et al. [2] and in 2010 Li et al. [3] grew single crystals activated with Nd³⁺ and Yb³⁺ ions, respectively, using the Czochralski technique. Analysis of spectroscopic properties and laser parameters such as absorption and emission cross-sections, as well as studies of the dynamics of the excited states showed that the materials could be considered promising for applications in tunable lasers.

D. Zhao et al. [2] and H. Li et al. [3] describe grown BaLaLiWO₆ type single crystals, however, the state of the art still lacks detailed information on their structural characteristics (solved crystal structures) and spectroscopic analysis of powder materials.

In 2024, K.A. Prokop et al. carried out very detailed studies on a series of BaLaLiWO₆ type tungstates activated with Nd³⁺ ions obtained by solid-phase reaction. The experimental studies take into account both the optimization of the conditions for the synthesis of polycrystalline phase pure materials with crystallite sizes of several micrometers, as well as the solution of the crystal structure from a single crystal. Recorded wide absorption and emission bands for the Nd³⁺ ion indicate that BaLaLiWO₆ could be used as a tunable laser medium to obtain ultrashort pulses [4].

In only a few reference works on micro powder BaLaLiWO₆ type tungstates activated with Eu³⁺, Dy³⁺/Eu³⁺, Mn⁴⁺ ions for use as WLEDs, the synthesis by solid-state reaction described therein does not actually yield phase-pure materials [5-9]. Only in the work on BaLaLiWO₆ activated with Pr³ ions, tested for applications in optical thermometry, the authors used an excess of one of the substrates, i.e. Li₂CO₃, to eliminate the risk of the formation of the contaminating phase in the form of BaWO₄ [10]. However, there are no reports in the literature describing the preparation of phase-pure nano-sized materials of ALaBB'O₆ type (where A = Sr, Ba, B = Li, Na, K, B '= Mo, W).

In the art, there are many methods for synthesizing nanomaterials, which methods can be generally divided into two categories, namely bottom-up and top-down techniques. The most frequently described technique for obtaining nanocrystalline chemical compounds in the literature is the bottom-up method, in which nanomaterials are prepared by controlled growth of crystallites to a certain size. Most often, wet chemical reaction methods are used, such as hydrothermal, solvothermal and sol-gel methods, the Pechini method or the combustion technique. They allow for the control of crystallite sizes, agglomeration degree, morphology, and chemical composition. However, the literature provides no information regarding the preparation of nanomaterials with more complex chemical structures, such as AA'BB'O₆ type oxide double perovskites described herein. Most publications focus on the roasting of mixtures of chemical compounds in appropriate proportions and on the creation of thermodynamic equilibrium models in multicomponent systems. However, the major synthetic method is solid-phase reaction, which allows for obtaining well crystallized products with micrometer-sized crystallites.

The aim of the invention was to develop a nanocrystalline phase-pure material and a method for obtaining the nanocrystalline phase-pure material with the double-perovskite structure crystallizing in the cubic crystal system in space group *Fm3m* No. 225 and with point symmetry O⁵ₕ, with crystallite sizes not exceeding 40 nm, which material would be characterized by high efficiency and reduced process energy consumption.

Surprisingly, all the above-mentioned technical problems have been solved by the present invention.

The object of the invention is a nanocrystalline material from the double perovskite family of the general formula:

Ba_{X}Sr₁₋ₓLaLiWO₆

wherein X is 0 to 1, crystallizing in the cubic crystal system in space group *Fm3m* and point symmetry *O*⁵ₕ having a nanocrystallite size not exceeding 40 nm.

Preferably, the material is characterized in that it is selected from a group comprising: BaLaLiWO₆, SrLaLiWO₆, Ba_{0.1}Sr_{0.9}LaLiWO₆, Ba_{0.2}Sr_{0.8}LaLiWO₆, Ba_{0.3}Sr_{0.7}LaLiWO₆, Ba_{0.4}Sr_{0.6}LaLiWO₆, Ba_{0.5}Sr_{0.5}LaLiWO₆, Ba_{0.6}Sr_{0.4}LaLiWO₆, Ba_{0.7}Sr_{0.3}LaLiWO₆, Ba_{0.8}Sr_{0.2}LaLiWO₆, Ba_{0.9}Sr_{0.1}LaLiWO₆.

Preferably, the material is characterized in that a nanocrystallite size is from 5 nm to 40 nm.

Preferably, the material is characterized in that a nanocrystallite size is from 10 nm to 30 nm.

Another object of the invention is a method for obtaining the nanocrystalline material from the double perovskite family of the general formula: Ba_{X}Sr₁₋ₓLaLiWO₆, wherein X is 0 to 1, crystallizing in the cubic crystal system in space group *Fm3m* and point symmetry *O*⁵ₕ, comprising the following steps:
a) preparing a suspension of reactants in a volatile organic solvent, containing barium carbonate or strontium carbonate, lithium carbonate, lanthanum oxide and ammonium tungstate hydrate, wherein the contents of dry mixture of reactants in the suspension is from 20 to 40 wt. %, followed by milling for a time of 8 to 24 h, and then
b) roasting the resulting suspension of reactants at a temperature in the range of 400°C to 600°C for a time of 8 to 24 h, after which the mixture is cooled to ambient temperature, and then
c) preparing a suspension of the mixture of step b) in a volatile organic solvent, wherein the ratio of the solvent to the dry weight of the sample is from 4:1 to 8:1, and then grinding the suspension until a homogeneous form of the mixture is obtained,
d) roasting the resulting homogeneous mixture at a temperature in the range of 600°C to 700°C for a time of 8 to 24 h, then cooling the sample to ambient temperature, and then
e) preparing a suspension of the mixture of step d) in a volatile organic solvent, wherein the ratio of the solvent to the dry weight of the sample is from 4:1 to 8:1, and then grinding the suspension until a homogeneous form of the mixture is obtained,
f) milling the resulting mixture of step e) for a time of 8 to 24 h.

Preferably, the method is characterized in that the heating of the homogeneous mixture in step b) is carried out at a temperature in the range of 450°C to 550°C for a time of 8 to 12 h, preferably at a temperature in the range of 500°C to 550°C for a time of 8 to 10 h.

Preferably, the method is characterized in that the heating of the homogeneous mixture in step d) is carried out at a temperature in the range of 650°C to 700°C for a time of 8 to 12 h, preferably at a temperature of 650°C to 700°C for a time of 8 to 10 h.

Preferably, the method is characterized in that the rate of temperature rise is from 1°C to 10°C per minute, preferably from 3°C to 7°C per minute, most preferably from 5°C to 6°C per minute.

Preferably, the method is characterized in that the molar ratio of the following reactants in the mixture: barium carbonate or strontium carbonate, lithium carbonate, lanthanum oxide, ammonium tungstate hydrate is 12 : 6-7.2 : 6 : 1, respectively.

Preferably, the method is characterized in that a volatile organic solvent with a boiling point not greater than 100°C, preferably not greater than 85°C, is used.

Preferably, the method is characterized in that in step a) a suspension of reactants in a volatile organic solvent containing from 25 to 35 wt. % of dry mixture of reactants is prepared.

Preferably, the method is characterised in that the lanthanum oxide, prior to the mixing of the reactants, is roasted at a temperature of at least 850°C for at least 12 h.

Preferably, the method is characterized in that the milling process is cyclic ball milling, wherein the cyclic ball milling is performed with balls with a diameter in the range of 1 to 10 mm in a number of 5 to 20 at a rotational speed of not more than 700 rpm, preferably with balls with a diameter of 5 mm in a number of 10 to 12 at a rotational speed of not more than 700 rpm.

Preferably, the method is characterized in that the cyclic ball milling is performed in successive 15-minute milling cycles and then a 15-minute break.

A further object of the invention is the use of the nanocrystalline material of the invention for the production of optical materials, in particular for the production of nanomaterial laser sources, phosphors or scintillators.

The object of the invention is presented in the drawing in which:

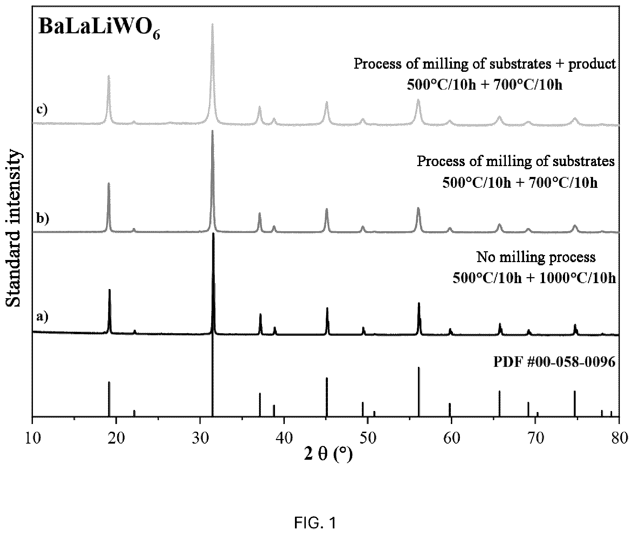

Figure 1 shows XRD patterns recorded for BaLaLiWO₆ obtained by solid-state reaction: (a) before milling, (b) after the synthesis has been modified using suitably the ball milling processes for the substrates alone, and (c) after the synthesis has been modified using suitably the ball milling processes for both the substrates and the obtained product;

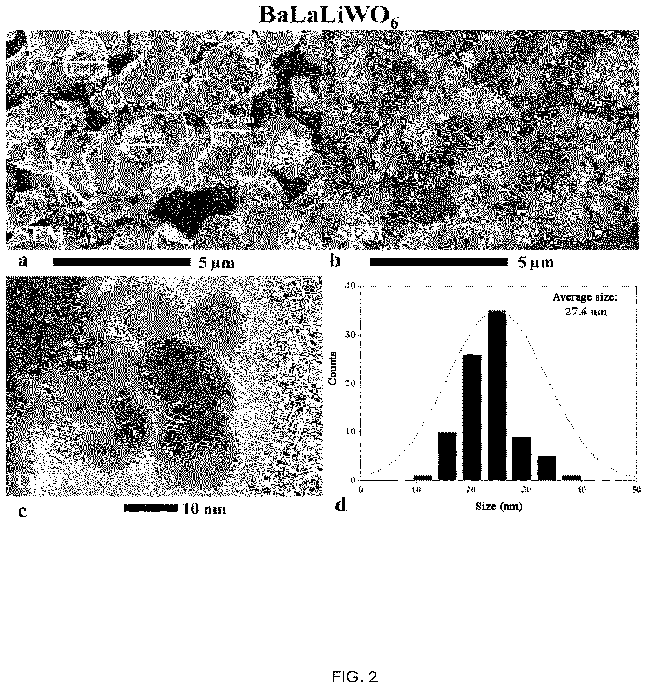

Figure 2 shows SEM (a and b) and TEM images (c) recorded for BaLaLiWO₆ obtained by solid-state reaction: (a) before milling, (b) after the synthesis has been modified using suitably the ball milling processes for the substrates alone, and (c) after the synthesis has been modified using suitably the ball milling processes for both the substrates and the obtained product, (d) histograms showing the size distribution of obtained crystallites;

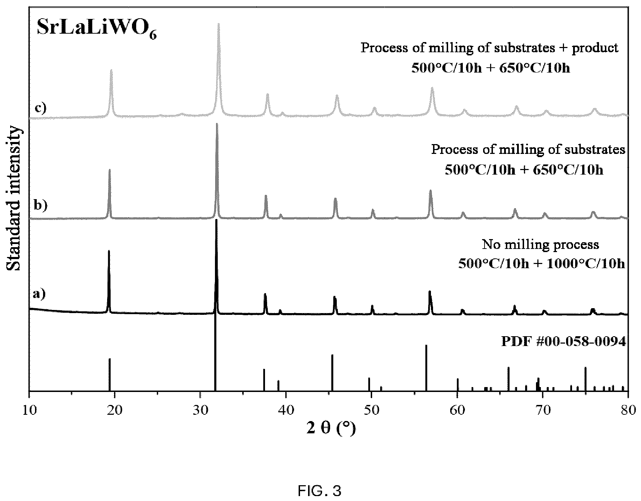

Figure 3 shows XRD patterns recorded for SrLaLiWO₆ obtained by solid-state reaction: (a) before milling, (b) after the synthesis has been modified using suitably the ball milling processes for the substrates alone, and (c) after the synthesis has been modified using suitably the ball milling processes for both the substrates and the obtained product;

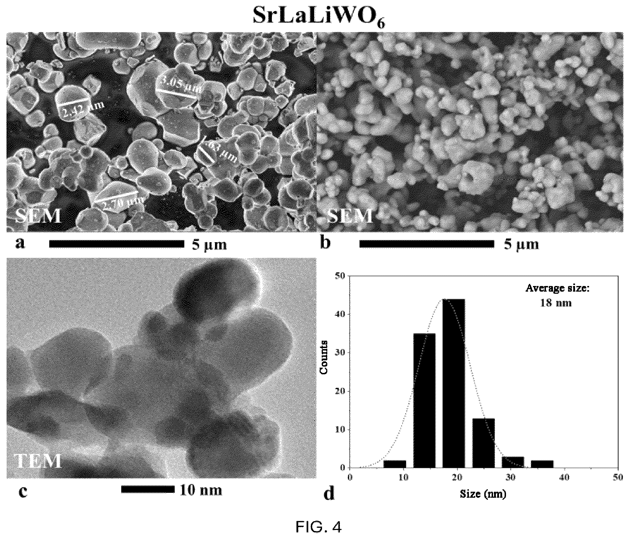

Figure 4 shows SEM (a and b) and TEM images (c) recorded for SrLaLiWO₆ obtained by solid-state reaction: (a) before milling, (b) after the synthesis has been modified using suitably the ball milling processes for the substrates alone, and (c) after the synthesis has been modified using suitably the ball milling processes for both the substrates and the obtained product, (d) histograms showing the size distribution of obtained crystallites;

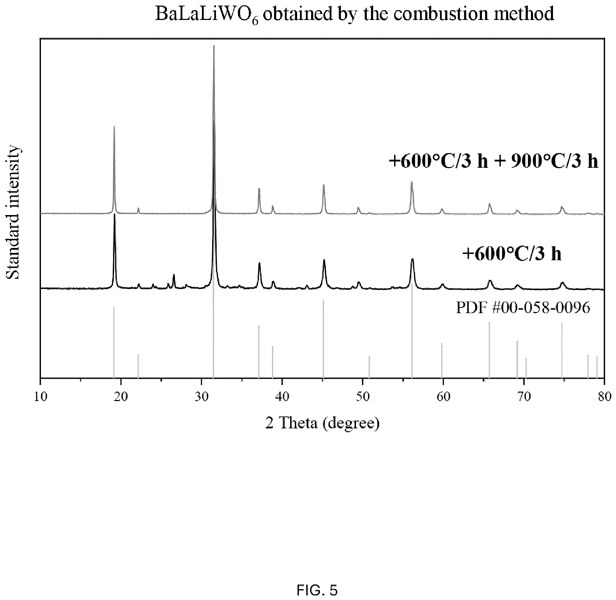

Figure 5 shows XRD patterns for BaLaLiWO₆ obtained by the combustion method after roasting at temperatures of 600°C / 3h and 600°C / 3h + 900°C / 3h;
Figure 6 shows TEM and SEM images for BaLaLiWO₆ obtained by the combustion method after roasting at temperatures of 600°C / 3h and 600°C / 3h + 900°C / 3h.

The advantage of the solution of the invention is the development of a nanocrystalline phase-pure material and a method for producing this material with a double perovskite structure, the cubic crystal system and a nanocrystallite size not exceeding 40 nm and with a high homogeneity of the material. Another advantage is high efficiency of the production process for the nanomaterial of the present invention as well as reduced costs and a relatively short synthesis time.

A general procedure for obtaining nanocrystalline materials from the double perovskite family of the general formula Ba_{X}Sr₁₋ₓLaLiWO₆

The synthesis of BaLaLiWO₆ crystallizing in the cubic crystal system can be described by the following equation:

12 BaCO₃ + 6 La₂O₃ + 6 Li₂CO₃ + (NH₄)₁₀H₂W₁₂O₄₂ · 4H₂O → 12 BaLaLiWO₆ + 18 CO₂↑ + 10 H₂O + 10 NH₃↑

In turn, the synthesis of SrLaLiWO₆ crystallizing in the cubic crystal system can be described by the following equation:

12 SrCO₃ + 6 La₂O₃ + 6 Li₂CO₃ + (NH₄)₁₀H₂W₁₂O₄₂ · 4H₂O → 12 SrLaLiWO₆ + 18 CO₂↑ + 10 H₂O + 10 NH₃↑

According to the present invention, a nanocrystalline material is obtained selected from a group comprising: BaLaLiWO₆, SrLaLiWO₆, Ba_{0.1}Sr_{0.9}LaLiWO₆, Ba_{0.2}Sr_{0.8}LaLiWO₆, Ba_{0.3}Sr_{0.7}LaLiWO₆, Ba_{0.4}Sr_{0.6}LaLiWO₆, Ba_{0.5}Sr_{0.5}LaLiWO₆, Ba_{0.6}Sr_{0.4}LaLiWO₆, Ba_{0.7}Sr_{0.3}LaLiWO₆, Ba_{0.8}Sr_{0.2}LaLiWO₆, Ba_{0.9}Sr_{0.1}LaLiWO₆, wherein with the method of the invention it is possible to obtain said combinations with any weight ratio of barium and strontium (Ba_{X}Sr_{1-X} where X is any number in the range of 0 to 1), while meeting the following condition: the sum of the weight contents of barium and strontium designated as (Ba_{X}Sr_{1-X}) must be 1.

For the synthesis of nanomaterials of the invention of the general formula: Ba_{X}Sr_{1-X}LaLiWO ₆, where X is any number in the range of 0 to 1, commercial chemical reagents such as: BaCO₃ (barium carbonate, Aldrich, 99.999%), SrCO₃ (strontium carbonate, Aldrich, 99.999%), Li₂CO₃ (lithium carbonate, Acros Organics, 99.999%), La₂O₃ (Stanford Materials, 99.999%) and (NH₄)₁₀H₂W₁₂O₄₂ · 4H₂O (ammonium tungstate hydrate, Aldrich, 99.99%) were used.

According to the present invention, a volatile organic solvent is a solvent having a boiling point not greater than 100°C, preferably not greater than 85°C. Typical solvents can be: methanol, ethanol, isopropanol, acetone.

Due to the hygroscopic nature of lanthanide oxides, before starting the synthesis, lanthanum oxide is each time roasted at a temperature of 850°C for 12 h in air to remove the water adsorbed on the surface and any carbonates. Lithium carbonate acts not only as a substrate, but also as a flux, which allows for better reacting of substrates and obtaining a product with high phase purity.

According to the present invention, cyclic ball milling is performed with balls with a diameter in the range of 1 to 10 mm, preferably 4 to 6 mm, most preferably 5 mm, wherein the number of balls should be from 5 to 20, preferably from 10 to 12 per a single bowl of the ball mill, and the rotational speed in the ball mill should not exceed 700 rpm.

For the ball milling procedure, a FRITSCH planetary mill equipped with agate bowls and agate balls (with a diameter of 5 mm) was used. 12 balls were used for the procedure. Milling is performed under the following conditions: 35% by weight of powder in a suspension of a volatile organic solvent, e.g. acetone or ethanol (with a purity of not less than 99%) at 700 rpm. The milling is performed in cycles of 15 minutes of operation, 15 minutes of break, wherein the total milling time should be not shorter than 8 h, including 4 hours of milling and 4 hours of break, and not longer than 24 hours, including 12 hours of milling and 12 hours of break. Inadequate adjustment of the diameter and number of balls, rotational speed, cyclicity of the milling process may cause the overheating of the mixture and, consequently, lead to contamination with undesirable phases.

The amounts of reactants are weighed in appropriate molar ratios (stoichiometrically according to the reaction equations above), namely: 12 eq. BaCO₃ or SrCO₃, 6 eq. Li₂CO₃, 6 eq. La₂O₃, 1 eq. (NH₄)₁₀H₂W₁₂O₄₂ · 4H₂O and homogenized by ball milling. Taking into account the volatility of lithium oxide formed during the reaction, samples are each time prepared with a 20% mol. excess of Li₂CO₃.

The mixture obtained by ball milling is roasted in air in corundum crucibles in two stages.

According to the present invention, the contents of dry mixture of reactants in the volatile organic solvent suspension subjected to roasting should be from 20 to 40 wt. %, and most preferably from 25 to 35 wt. %. Too low, i.e. below 20 wt. %, and too high, i.e. above 40 wt. %, contents of dry mixture of reactants prevent effective activation of the reactants.

In the first step, the mixture is heated at a temperature in the range of 400°C to 600°C for a time of 8 to 24 h, preferably at a temperature in the range of 450°C to 550°C for a time of 8 to 12 h, and most preferably at a temperature in the range of 500°C to 550°C for a time of 8 to 10 h, wherein the rate of temperature rise is from 1°C to 10°C per minute, preferably from 3°C to 7°C per minute, most preferably from 5°C to 6°C per minute, and then the sample is cooled to room temperature (allowed to cool down), and then a volatile organic solvent is added to the sample so obtained, wherein the ratio of the solvent to the dry weight of the sample is from 4:1 to 8:1, and then manually ground in an agate mortar until a homogeneous mixture is obtained.

In the second step, the ground mixture is heated at a temperature in the range of 600°C to 700°C for a time of 8 to 24 h, preferably at a temperature in the range of 650°C to 700°C for a time of 8 to 12 h, preferably at a temperature of 650°C to 700°C for a time of 8 to 10 h, wherein the rate of temperature rise is from 1°C to 10°C per minute, preferably from 3°C to 7°C per minute, most preferably from 5°C to 6°C per minute, after which the samples are cooled to room temperature (allowed to cool down), and then a volatile organic solvent is added to the sample so obtained, wherein the ratio of the solvent to the dry mass of the sample is from 4:1 to 8:1, after which it is ground manually in an agate mortar until a homogeneous mixture is obtained.

A particularly important aspect of the invention is the steps of heating the mixture of reactants, namely the temperature and the soaking time, as detailed above, whereby phase-pure compounds are obtained.

The resulting homogeneous suspension is ball milled under the following conditions: 35% by weight of powder in a suspension of a volatile organic solvent, e.g. isopropanol or ethanol (with a purity of not less than 99%) at 700 rpm. The milling is performed in cycles of 15 minutes of operation, 15 minutes of break. 12 balls with a diameter of 5 mm were used for the procedure. The total time of the milling procedure was 12 hours, including 6 hours of milling and 6 hours of break time.

The phase purity of the tested samples was controlled after each stage of roasting (soaking) of the samples using the powder X-ray diffraction (XRD) method. Measurements were made using a D8 Advance X-ray diffractometer (Bruker). The conditions for the measurements were as follows: room temperature, 10-80 20 range, scanning coefficient: 0.008°, counting time: 5s per step. For the experiment, CuKα radiation with Ni filter (Kα₁₊₂, λ= 0.15418 nm) was used.

The morphology and size of crystallites of obtained materials were examined by electron transmission microscopy (TEM). A Tecnai G2 20 X-Twin TEM microscope (Fei, Hillsboro, USA) equipped with a Penta FET EDX detector (Oxford Instruments) was used for the experiment. Observations were carried out at 200 kV. A suspension of sample in ethanol was used for the tests and was then applied to a copper-coated carbon mesh and then air dried.

The morphology and size of crystallites of obtained material were also examined by electron scanning microscopy (SEM). A SEM FEI Helios NanoLab 660 microscope equipped with EDS was used for the experiment. For better image resolution, immersion mode using a through-the-lens detector (TLD) was applied. Observations were carried out in secondary electrons (SE) mode at an accelerating voltage of 2.00 kV and a beam intensity of 50 pA. The surface of the samples was not coated with gold or carbon.

Detailed embodiments are set forth below, wherein the object of the present invention is not limited to those embodiments only.

### Example 1 - Method for obtaining submicrocrystalline BaLaLiWO₆ type tungstate, crystallizing in the cubic crystal system, by solid-state reaction preceded by the process of ball milling of substrates

For the synthesis of BaLaLiWO₆ type submicromaterials, the following chemical reagents are weighed: BaCO₃, Li₂CO₃, La₂O₃ and (NH₄)₁₀H₂W₁₂O₄₂ · 4H₂O in the amounts specified in the general procedure above, after which the mixture is homogenized by ball milling. For the ball milling procedure, a FRITSCH planetary mill equipped with agate bowls and agate balls (with a diameter of 5 mm) was used. 12 balls were used for the procedure. The procedure was carried out under the following conditions: 35% by weight of powder in ethanol suspension (with a purity of 99%) at 700 rpm. The milling was carried out in cycles of 15 minutes of operation, 15 minutes of break. The total time of the milling procedure was 24 hours, including 12 hours of milling and 12 hours of break time.

In the first step, the mixture is heated at a temperature of 500°C for 10 h, wherein the rate of temperature rise is 5°C±1°C per minute, after which the sample is cooled to room temperature (allowed to cool down), and then acetone is added to the sample so obtained, wherein the ratio of acetone to the dry weight of the sample is from 4:1 to 8:1, after which it is ground manually in an agate mortar until a homogeneous mixture is obtained.

In the second step, the ground mixture is heated at a temperature of 700°C for 10 h, wherein the rate of temperature rise is 5°C±1°C per minute, after which the samples are cooled to room temperature (allowed to cool down), and then acetone is added to the sample so obtained, wherein the ratio of acetone to the dry weight of the sample is from 4:1 to 8:1, after which it is ground manually in an agate mortar until a homogeneous mixture is obtained.

The phase purity of the tested samples was controlled after each stage of roasting of the samples using the powder X-ray diffraction (XRD) method as described in the general procedure.

The diffraction pattern of the obtained material allowed to identify the pure phase of the BaLaLiWO₆ type product, crystallizing in the cubic crystal system in space group *Fm3m* (No. 225), Z = 4. The positions of reflections correspond to the standard (PDF # 00-058-0096), and their full-width at half-maximum (FWHM) indicates the micrometric size of the crystallites. No additional reflections indicating the presence of a different phase were observed (Figure 1b).

Particular attention is paid to a greater FWHM of reflections for the material obtained after the final heat treatment step at a temperature of 700°C for 10 hours, compared to the tungstate described in Comparative Example 3 obtained without the milling process in two steps: 1) 500°C for 10h and 2) 1000°C for 10h. This results from the lowering of the synthesis temperature, caused by the earlier substrate ball milling process before the start of heating.

The morphology and size of the crystallites of obtained material were examined by electron scanning microscopy (SEM) as described in the general procedure.

The submicron nature of the material obtained as described above was confirmed using SEM scanning microscopy.

The resulting BaLaLiWO₆ tungstate is homogeneous and properly formed (Figure 2b). It is formed by crystals with a regular, spherical shape, for which the boundaries between the crystallites are clearly visible. Occasionally, crystallites can be found with a minimum size of approx. 100 nm and a maximum size of approx. 1 µm, however, the size of most crystallites is in the range of 200-700 nm.

### Example 2 - Method for obtaining nanocrystalline BaLaLiW₆ type tungstate, crystallizing in the cubic crystal system, by solid-state reaction with the ball milling of a mixture of substrates before the reaction and of the product obtained

For the synthesis of BaLaLiWO₆ type nanomaterials, the following chemical reagents are weighed: BaCO₃, Li₂CO₃, La₂O₃ and (NH₄)₁₀H₂W₁₂O₄₂ · 4H₂O in the amounts specified in the general procedure above, after which the mixture is homogenized by ball milling. For the ball milling procedure, a FRITSCH planetary mill equipped with agate bowls and agate balls (with a diameter of 5 mm) was used. 12 balls were used for the procedure. The milling was performed under the following conditions: 35% by weight of powder in ethanol suspension (with a purity of 99%) was milled at 700 rpm. The milling was carried out in cycles of 15 minutes of operation, 15 minutes of break. The total milling time was 24 hours, including 12 hours of milling and 12 hours of break time.

The mixture obtained by ball milling was roasted in air in a corundum crucible in two stages.

In the first step, the mixture is heated at a temperature of 500°C for 10 h, wherein the rate of temperature rise is 5°C±1°C per minute, after which the sample is cooled to room temperature (allowed to cool down), and then acetone is added to the sample so obtained, wherein the ratio of acetone to the dry weight of the sample is 4:1 to 8:1, after which it is ground manually in an agate mortar until a homogeneous mixture is obtained.

In the second step, the ground mixture is heated at a temperature of 700°C for 10 h, wherein the rate of temperature rise is 5°C±1°C per minute, after which the samples are cooled to room temperature (allowed to cool down), and then acetone is added to the sample so obtained, wherein the ratio of acetone to the dry mass of the sample is 4:1 to 8:1, after which it is ground manually in an agate mortar until a homogeneous mixture is obtained.

After obtaining the BaLaLiWO₆ product after the second stage of heating, an additional ball milling process was applied, where the milling was carried out under the following conditions: 35% by weight of powder in ethanol suspension (with a purity of 99%) at 700 rpm. The milling was carried out in cycles of 15 minutes of operation, 15 minutes of break. 12 balls with a diameter of 5 mm were used for the procedure. The total time of the milling procedure was 12 hours, including 6 hours of milling and 6 hours of break time.

The phase purity of the tested samples was controlled after each stage of roasting of the samples using the powder X-ray diffraction (XRD) method as described in the general procedure.

The diffraction pattern of the obtained nanomaterial allowed for straightforward identification of the pure phase of the BaLaLiWO₆ type compound, crystallizing in the cubic crystal system in space group *Fm3m* (No. 225), Z = 4. The positions of reflections remain in accordance with the standard (PDF #00-058-0096). The reflections visible in the obtained diffraction pattern are characterized by the largest FWHM of all synthesized materials, which suggests the smallest size of crystallites (Figure 1c), owing to the use of the method of the invention and solid-phase reaction.

The morphology and size of the crystallites of the obtained material were examined by electron scanning microscopy (SEM) and transmission electron microscopy (TEM) as described in the general procedure.

The obtained BaLaLiWO₆ tungstate has crystals with a size in the range of 10 to 40 nm (Figure 2c). The distribution of crystallites shown in the histogram indicates a shape characteristic of the Gaussian distribution with an average size of crystallites of 27.6 nm (Figure 2d).

### Comparative Example 3 - Method for obtaining microcrystalline BaLaLiWO₆ type tungstate, crystallizing in the cubic crystal system, by solid-state reaction without the milling process

For the synthesis of BaLaLiWO₆ type micromaterials, the following chemical reagents are weighed: BaCO₃, Li₂CO₃, La₂O₃ and (NH₄)₁₀H₂W₁₂O₄₂ · 4H₂O in the amounts specified in the general procedure above, after which the mixture of reactants is ground manually with acetone, wherein the ratio of acetone to the dry weight of the sample is 4:1 to 8:1, in an agate mortar, after which the resulting mixture is roasted in air in a corundum crucible in two stages.

In the first step, the mixture is heated at a temperature of 500°C for 10 h, wherein the rate of temperature rise is 5°C±1°C per minute, after which the sample is cooled to room temperature (allowed to cool down), and then acetone is added to the sample so obtained, wherein the ratio of acetone to the dry weight of the sample is 4:1 to 8:1, after which it is ground manually in an agate mortar until a homogeneous mixture is obtained.

In the second step, the ground mixture is heated at a temperature of 1000°C for 10 h, wherein the rate of temperature rise is 5°C±1°C per minute, after which the samples are cooled to room temperature (allowed to cool down), and then acetone is added to the sample so obtained, wherein the ratio of acetone to the dry weight of the sample is from 4:1 to 8:1, after which it is ground manually in an agate mortar until a homogeneous mixture is obtained.

The phase purity of the tested samples was controlled after each stage of roasting of the samples using the powder X-ray diffraction (XRD) method as described in the general procedure.

The diffraction pattern of the obtained material allowed for the identification of the pure phase of the BaLaLiWO₆ type compound, crystallizing in the cubic crystal system in space group *Fm3m* (No. 225), Z = 4. The positions of narrow reflections are in accordance with the standard (PDF # 00-058-0096), and their FWHM indicates the micrometric size of the crystals. No additional reflections indicating the presence of a different phase were observed (Figure 1a).

The morphology and size of the crystallites of obtained material were examined by electron scanning microscopy (SEM) as described in the general procedure.

The resulting BaLaLiWO₆ tungstate is homogeneous and properly formed (Figure 2a). It is formed by crystals with a regular, spherical shape, for which the boundaries between the crystallites are clearly visible. Occasionally, crystallites can be found with a minimum size of approx. 700 nm and a maximum size of approx. 4.5 µm, however, the size of most crystallites is in the range of 2-3 µm.

### Example 4 - Method for obtaining sub-microcrystalline SrLaLiWO₆ type tungstate, crystallizing in the cubic crystal system, by solid-state reaction preceded by the process of the ball milling of substrates

For the synthesis of SrLaLiWO₆ type submicromaterials, the following chemical reagents are weighed: SrCO₃, Li₂CO₃, La₂O₃ and (NH₄)₁₀H₂W₁₂O₄₂ · 4H₂O in the amounts specified in the general procedure above, after which the mixture is homogenized by ball milling. For the ball milling procedure, a FRITSCH planetary mill equipped with agate bowls and agate balls (with a diameter of 5 mm) was used. 12 balls were used for the procedure. The procedure was carried out under the following conditions: 35% by weight of powder in ethanol suspension (with a purity of 99%) at 700 rpm. The milling was carried out in cycles of 15 minutes of operation, 15 minutes of break. The total time of the milling procedure was 24 hours, including 12 hours of milling and 12 hours of break time. The mixture obtained by ball milling was roasted in air in corundum crucibles in two stages.

In the first step, the mixture is heated at a temperature of 500°C for 10 h, wherein the rate of temperature rise is 5°C±1°C per minute, after which the sample is cooled to room temperature (allowed to cool down), and then acetone is added to the sample so obtained, wherein the ratio of acetone to the dry weight of the sample is from 4:1 to 8:1, after which it is ground manually in an agate mortar until a homogeneous mixture is obtained.

In the second step, the ground mixture is heated at a temperature of 650°C for 10 h, wherein the rate of temperature rise is 5°C±1°C per minute, after which the samples are cooled to room temperature (allowed to cool down), and then acetone is added to the sample so obtained, wherein the ratio of acetone to the dry weight of the sample is from 4:1 to 8:1, after which it is ground manually in an agate mortar until a homogeneous mixture is obtained.

The phase purity of the tested samples was controlled after each stage of roasting of the samples using the powder X-ray diffraction (XRD) method as described in the general procedure.

The diffraction pattern of the obtained material allowed for the identification of the pure phase of the SrLaLiWO₆ type compound, crystallizing in the cubic crystal system in space group *Fm3m* (No. 225), Z = 4. The positions of reflections correspond to the standard (PDF # 00-058-0094) and their FWHM indicates a micrometric size of the crystallites. No additional reflections indicating the presence of a different phase were observed (Figure 3b).

Particular attention is paid to a greater FWHM of reflections for the material obtained after the final heat treatment step at a temperature of 650°C for 10h, compared to the tungstate described in the first example obtained without the milling process in two steps: 1) 500°C for 10h and 2) 1000°C for 10h. This results from the lowering of synthesis temperature, caused by the earlier substrate ball milling process before the start of heating.

The morphology and size of the crystallites of obtained material were examined by electron scanning microscopy (SEM) as described in the general procedure.

The submicron nature of the material obtained as described above was confirmed using SEM scanning microscopy. The examination of morphology indicates homogeneous material with a spherical shape of crystallites with a size ranging from 200 nm to 800 nm, with clearly outlined boundaries of microcrystals. The crystals are regular and separated from one another (Figure 4b).

The resulting SrLaLiWO₆ tungstate is homogeneous and properly formed (Figure 4b). It is formed by crystals with a regular, spherical shape, for which the boundaries between the crystallites are clearly visible. Occasionally, crystallites can be found with a minimum size of approx. 100 nm and a maximum size of approx. 1 µm, however, most crystallites are 200-500 nm in size.

### Example 5 - Method for obtaining nanocrystalline SrLaLiWO₆ type tungstate, crystallizing in the cubic crystal system, by solid-state reaction with the process of ball milling of a mixture of substrates before reaction and of the product obtained

For the synthesis of SrLaLiWO₆ type nanomaterials, the following chemical reagents are weighed: SrCO3, Li₂CO₃, La₂O₃ and (NH₄)₁₀H₂W₁₂O₄₂ · 4H₂O in the amounts specified in the general procedure above, after which the mixture is homogenized by ball milling. For the ball milling procedure, a FRITSCH planetary mill equipped with agate bowls and balls (with a diameter of 5 mm) was used. 12 balls were used for the procedure. The procedure was performed under the following conditions: 35% by weight of powder in ethanol suspension (with a purity of 99%) at 700 rpm. The milling was carried out in cycles of 15 minutes of operation, 15 minutes of break. The total time of the milling procedure was 24 hours, including 12 hours of milling and 12 hours of break time.

The mixture obtained by ball milling was roasted in air in a corundum crucible in two stages.

In the first step, the mixture is heated at a temperature of 500°C for 10 h, wherein the rate of temperature rise is 5°C±1 °C per minute, after which the sample is cooled to room temperature (allowed to cool down), and then acetone is added to the sample so obtained, wherein the ratio of acetone to the dry weight of the sample is 4:1 to 8:1, after which it is ground manually in an agate mortar until a homogeneous mixture is obtained.

In the second step, the ground mixture is heated at a temperature of 650°C for 10 h, wherein the rate of temperature rise is 5°C±1°C per minute, after which the samples are cooled to room temperature (allowed to cool down), and then acetone is added to the sample so obtained, wherein the ratio of acetone to the dry weight of the sample is from 4:1 to 8:1, after which it is ground manually in an agate mortar until a homogeneous mixture is obtained.

After obtaining the SrLaLiWO₆ product after the second stage of 650°C for 10 hours, an additional ball milling process was applied.

The procedure was carried out under the following conditions: 35% by weight of powder in ethanol suspension (with a purity of 99%) at 700 rpm. The milling was carried out in cycles of 15 minutes of operation, 15 minutes of break. 12 balls were used for the procedure. The total time of the milling procedure was 12 hours, including 6 hours of milling and 6 hours of break time.

The phase purity of the tested samples was controlled after each stage of roasting of the samples using the powder X-ray diffraction (XRD) method as described in the general procedure.

The diffraction pattern of the obtained nanomaterial allowed for straightforward identification of the pure phase of the SrLaLiWO₆ type compound, crystallizing in the cubic crystal system in space group *Fm3m* (No. 225), Z = 4 (Figure 3c). The positions of reflections remain in accordance with the standard (PDF #00-058-0094). The reflections visible in the obtained diffraction pattern are characterized by the largest FWHM of all synthesized materials, which suggests the smallest size of crystallites, owing to the use of the method according to the invention and solid-phase reaction.

The morphology and size of the crystallites of the obtained material were examined by electron scanning microscopy (SEM) and transmission electron microscopy (TEM) as described in the general procedure.

A nanocrystalline material with a crystallite size in the range of 5 to 40 nm was obtained (Figure 4c). The distribution of crystallites shown in the histogram (Figure 4d) indicates the shape characteristic of the Gaussian distribution, with an average size of crystallites of 18 nm.

### Comparative Example 6 - Method for obtaining microcrystalline SrLaLiWO₆ type tungstate, crystallizing in the cubic crystal system, by solid-state reaction without the milling process

For the synthesis of SrLaLiWO₆ type micromaterials, the following chemical reagents are weighed: SrCO₃, Li₂CO₃, La₂O₃ and (NH₄)₁₀H₂W₁₂O₄₂ · 4H₂O in the amounts specified in the general procedure above, after which the mixture of reactants is ground manually with acetone in an agate mortar, wherein the ratio of acetone to dry weight of the sample is from 4:1 to 8:1, after which the resulting mixture is roasted in air in corundum crucibles in two stages.

In the first step, the mixture is heated at a temperature of 500°C for 10 h, wherein the rate of temperature rise is 5°C±1°C per minute, after which the sample is cooled to room temperature (allowed to cool down), and then acetone is added to the sample so obtained, wherein the ratio of acetone to the dry weight of the sample is from 4:1 to 8:1, after which it is ground manually in an agate mortar until a homogeneous mixture is obtained.

In the second step, the ground mixture is heated at a temperature of 1000°C for 10 h, wherein the rate of temperature rise is 5°C±1°C per minute, after which the samples are cooled to room temperature (allowed to cool down), and then acetone is added to the sample so obtained, wherein the ratio of acetone to the dry weight of the sample is from 4:1 to 8:1, after which it is ground manually in an agate mortar until a homogeneous mixture is obtained.

The phase purity of the tested samples was controlled after each stage of roasting of the samples using the powder X-ray diffraction (XRD) method as described in the general procedure.

The diffraction pattern of the obtained material allowed for the identification of the pure phase of the SrLaLiWO₆ type compound, crystallizing in the cubic crystal system in space group *Fm3m* (No. 225), Z = 4. The positions of narrow reflections are in accordance with the standard (PDF # 00-058-0094), and their FWHM indicates a micrometric size of crystallites. No additional reflections indicating the presence of a different phase were observed (Figure 4a).

The morphology and size of the crystallites of obtained material were examined by electron scanning microscopy (SEM) as described in the general procedure.

The resulting SrLaLiWO₆ tungstate is homogeneous and properly formed (Figure 4a). It is formed by crystals with a regular, spherical shape, for which the boundaries between the crystallites are clearly visible. Occasionally, crystallites can be found with a minimum size of approx. 600 nm and a maximum size of approx. 4.2 µm, however, most crystallites are 2-3 µm.

### Comparative Example 7 - Method for obtaining microcrystalline BaLaLiWO₆ type tungstate, crystallizing in the cubic crystal system, by the combustion method

The preparation of BaLaLiWO₆ tungstate crystallizing in the cubic crystal system was carried out using the combustion method, commonly used for the preparation of nanopowders. As precursors, nitrates of relevant metals were used, namely barium nitrate(V), lanthanum nitrate(V) hexahydrate, lithium nitrate(V), and ammonium tungstate with the addition of citric acid. The amounts of reactants were weighed in appropriate molar ratios (stoichiometrically according to the reaction equations above), namely: 12 eq. Ba(NO₃)2 or Sr(NO₃)2, 6 eq. LiNO₃, 6 eq. La(NO₃)₃ · 6 H₂O, 1 eq. (NH₄)₁₀H₂W₁₂O₄₂ · 4H₂O. Taking into account the volatility of the lithium oxide formed during the reaction, the sample was prepared with a 20% mol. excess of Li₂CO₃.

The synthesis was prepared assuming that 1 g of the product would be obtained. For the synthesis, a tall borosilicate grade 3.3 glass beaker was used. In the first step of the procedure, citric acid in an amount of 2.9862 g was dissolved in 100 mL of distilled water at a molar ratio of 8:1 (citric acid to the number of moles of metal in the target BaLaLiWO₆ product). The mixture was intensively stirred on a magnetic stirrer with a heating function. After full dissolution of citric acid, previously weighed metal nitrates were added to the beaker : Ba(NO₃)₂ in the amount of 0.4637 g; LiNO₃ in the amount of 0.1853 g and La(NO₃)₃ · 6 H₂O in the amount of 0.7688 g. The stirring was continued for about 30 minutes to obtain a clear solution. Then, a solution of ammonium tungstate hydrate was incorporated into the mixture by dissolving 0.4637 g of ammonium tungstate hydrate in 50 ml of distilled water. The mixture was heated to about 80°C and the stirring was continued until a clear solution was obtained. The solution was evaporated gradually at a temperature of 80°C for about 3 hours. The obtained thin film was subjected to the combustion process at a temperature of 600°C for 3 hours, wherein the rate of temperature rise was 5°C±1°C per minute. According to the X-ray diffraction pattern (XRD) (Figure 5), a regular phase of BaLaLiWO₆ was mainly obtained, however, reflections from impurities were also observed, i.e. From tetragonal BaWO₄ (PDF # 01-082-2636) and monoclinic BaLa₂WO₇ (PDF #00-093-0083). Additional soaking at a temperature 900°C for 3 hours, wherein the rate of temperature rise was 5°C±1°C per minute, allowed to obtain a single-phase BaLaLiWO₆ product.

Transmission electron microscopy (TEM) analysis (Figure 6) indicated that regardless of the soaking temperature used, it was not possible to obtain a nanomaterial powder with the size of crystallites below 100 nm. Moreover, additional soaking necessary to obtain a single-phase material led to a further increase in the size of crystallites.

The combustion method yielded submicrocrystalline BaLaLiWO₆ tungstate, which crystallizes in the cubic crystal system, contaminated with BaWO₄ and BaLa₂WO₇ phases. Additional soaking of the product at a temperature of 900°C allowed to obtain a single-phase product, but led to an increase in the size of crystallites above 100 nm. Ultimately, regardless of the soaking conditions, a nanomaterial with the size of crystallites below 100 nm was not obtained.

### References:

1. L.K. Brixner, New ordered perovskites, Mat. Res. Bull. 9 (1974) 1041-1044.
2. D. Zhao, Z. Lin, L. Zhang, G. Wang, Growth and spectroscopic properties of Nd3+: BaLaLiWO6 crystal, J. Cryst. Growth 299 (2007) 223-226.
3. H. Li, L. Zhang, Z. Lin, G. Wang, Growth and spectroscopic properties of Yb3+-doped BaLaLiWO6 crystal, J. Alloys Compd. 493 (2010) 372-375.
4. K. A. Prokop, E. Tomaszewicz, M. Siczek, Y. Guyot, G. Boulon, M. Guzik, Unexpected dominant substitution of Ba2+ instead of La3+ in cubic Nd3+-doped BaLaLiWO6 perovskites, Acta Mater. 277 (2024) 120131.
5. X. Wu, X. Zhao, Q. Ren, L. Du, M. Pei, O. Hai, Tuning of emission by effect of local symmetry in BaLaLiWO6:Dy3+/Eu3+ for WLEDs, Ceram. Int. 48 (2022) 18793-18802.
6. X. Zhao, X. Wu, Q. Ren, L. Du, M. Pei, O. Hai, Complete B-site cation regulation accomplish UV-excited red phosphors in double perovskite oxides, J. Lumin. 252 (2022) 119402.
7. L. Li, Q. Cao, J. Xi, W. Wang, J. Wang, Y. Pan, X. Wei, Y. Li, Novel far-red emitting phosphor Mn4+-activated BaLaLiWO6 with excellent performance for indoor plant cultivation of light-emitting diodes, J. Alloys Compd. 934 (2023) 167927.
8. X. Zhao, X. Wu, Q. Ren, L. Du, M. Pei, O. Hai, Perovskite A-site symmetry tuning to achieve high quantum efficiency phosphor for WLED applications, Ceram. Int. 49 (2023) 4204-4212.
9. H. Jin, N. Fu, C. Wang, C. Qi, Z. Liu, D. Wang, L. Guan, F. Wang, X. Li, Sr/Ba Substitute-Induced Higher Thermal Stability far Red-Emitting Ba1-ySryLaLiWO6:Mn4+ Phosphor for Plant Growth Applications, Dalton Trans. 52 (2023) 78.
10. T. Pier, T. Jüstel, On the photoluminescence of the solid solution LiBaLa1-xPrxWO6 (x = 0.0-1.0), J. Lumin. 262 (2023) 119958.

## Claims

1. A nanocrystalline material from the double perovskite family of the general formula:
Ba_{X}Sr₁₋ₓLaLiWO₆
wherein X is 0 to 1, crystallizing in the cubic crystal system in space group *Fm3m* and point symmetry *O*⁵ₕ having a nanocrystallite size not exceeding 40 nm.

2. The nanocrystalline material of claim 1, **characterized in that** it is selected from the group comprising: BaLaLiWO₆, SrLaLiWO₆, Ba_{0.1}Sr_{0.9}LaLiWO₆, Ba_{0.2}Sr_{0.8}LaLiWO₆, Ba_{0.3}Sr_{0.7}LaLiWO₆, Ba_{0.4}Sr_{0.6}LaLiWO₆, Ba_{0.5}Sr_{0.5}LaLiWO₆, Ba_{0.6}Sr_{0.4}LaLiWO₆, Ba_{0.7}Sr_{0.3}LaLiWO₆, Ba_{0.8}Sr_{0.2}LaLiWO₆, Ba_{0.9}Sr_{0.1}LaLiWO₆.

3. The nanocrystalline material of any one of claims 1-2, **characterized in that** a nanocrystallite size is from 5 nm to 40 nm.

4. The nanocrystalline material of any one of claims 1-3, **characterized in that** a nanocrystallite size is from 10 nm to 30 nm.

5. A method for obtaining the nanocrystalline material from the double perovskite family of the general formula: Ba_{X}Sr₁₋ₓLaLiWO₆, wherein X is 0 to 1, crystallizing in the cubic crystal system in space group *Fm3m* and point symmetry *O*⁵ₕ, comprising the following steps:
a) preparing a suspension of reactants in a volatile organic solvent, containing barium carbonate or strontium carbonate, lithium carbonate, lanthanum oxide and ammonium tungstate hydrate, wherein the contents of dry mixture of reactants in the suspension is from 20 to 40 wt. %, followed by milling for a time of 8 to 24 h, and then
b) roasting the resulting suspension of reactants at a temperature in the range of 400°C to 600°C for a time of 8 to 24 h, after which the mixture is cooled to ambient temperature, and then
c) preparing a suspension of the mixture of step b) in a volatile organic solvent, wherein the ratio of the solvent to the dry weight of the sample is from 4:1 to 8:1, and then grinding the suspension until a homogeneous form of the mixture is obtained,
d) roasting the resulting homogeneous mixture at a temperature in the range of 600°C to 700°C for a time of 8 to 24 h, then cooling the sample to ambient temperature, and then
e) preparing a suspension of the mixture of step d) in a volatile organic solvent, wherein the ratio of the solvent to the dry weight of the sample is from 4:1 to 8:1, and then grinding the suspension until a homogeneous form of the mixture is obtained,
f) milling the resulting mixture of step e) for a time of 8 to 24 h.

6. The method of claim 5, **characterized in that** the heating of the homogeneous mixture in step b) is carried out at a temperature in the range of 450°C to 550°C for a time of 8 to 12 h, preferably at a temperature in the range of 500°C to 550°C for a time of 8 to 10 h.

7. The method of claim 5, **characterized in that** the heating of the homogeneous mixture in step d) is carried out at a temperature in the range of 650°C to 700°C for a time of 8 to 12 h, preferably at a temperature of 650°C to 700°C for a time of 8 to 10 h.

8. The method of any one of claims 5-7, **characterized in that** the rate of temperature rise is from 1°C to 10°C per minute, preferably from 3°C to 7°C per minute, most preferably from 5°C to 6°C per minute.

9. The method of claim 5, **characterized in that** the molar ratio of the following reactants in the mixture: barium carbonate or strontium carbonate, lithium carbonate, lanthanum oxide, ammonium tungstate hydrate is 12 : 6-7.2: 6 : 1, respectively.

10. The method of claim 5, **characterized in that** a volatile organic solvent having a boiling point of not more than 100°C, preferably not more than 70°C, is used.

11. The method of claim 5, **characterized in that** in step a) a suspension of reactants in a volatile organic solvent containing from 25 to 35 wt. % of dry mixture of reactants is prepared.

12. The method of claim 5, **characterized in that**, lanthanum oxide, prior to the mixing of reactants, is roasted at a temperature of at least 850°C for at least 12 h.

13. The method of claim 5, **characterized in that** the milling process is cyclic ball milling, wherein the cyclic ball milling is carried out with balls with a diameter in the range of 1 to 10 mm in a number of 5 to 20 at a rotational speed of not more than 700 rpm, preferably with balls with a diameter of 5 mm in a number of 10 to 12 at a rotational speed of not more than 700 rpm.

14. The method of any one of claims 13, **characterized in that** the cyclic ball milling is carried out in the following cycles: 15 minutes of milling and then 15 minutes of break.

15. The use of the nanocrystalline material of any one of claims 1-4 or obtained according to the method of any one of claims 5-14 for the production of optical materials, in particular for the production of nanomaterial laser sources, phosphors or scintillators.
